# EUROPEAN PATENT APPLICATION

(11) **EP 1 202 297 A2**
(43) Date of publication of application: **02.05.2002**
(21) Application number: 01308201.1
(22) Date of filing: 26.09.2001
(51) Int. Cl.: H01F 27/28

(54) **High Q spiral inductor**

(30) Priority: 23.10.2000 JP 2000328406
(71) Applicant: ALPS ELECTRIC CO., LTD., Ota-ku Tokyo 145 (JP)
(72) Inventor: Ueda, Kazuhiko, c/o Alps Electric Co. Ltd., Tokyo (JP); Miyazaki, Masami, c/o Alps Electric Co. Ltd., Tokyo (JP)
(74) Representative: Kensett, John Hinton

(57) **Abstract**

A spiral inductor according to the present invention is formed in the following manner. While the spacing between adjacent spiral turns of a conductor is the same, the width of an inner portion of the conductor is smaller than the width of an outer portion of the conductor. Thus, the inner portion of the conductor is far from the center, and hence magnetic lines of force have a small effect on opposed portions of the conductor. Thus, the inductance becomes large, and the spiral inductor has a higher Q compared with that of a conventional spiral inductor.

## Description

### BACKGROUND OF THE INVENTION

### 1. Field of the Invention

The present invention relates to spiral inductors suitable for use in transmitter-receiver units in cellular phones in a radio-frequency band.

### 2. Description of the Related Art

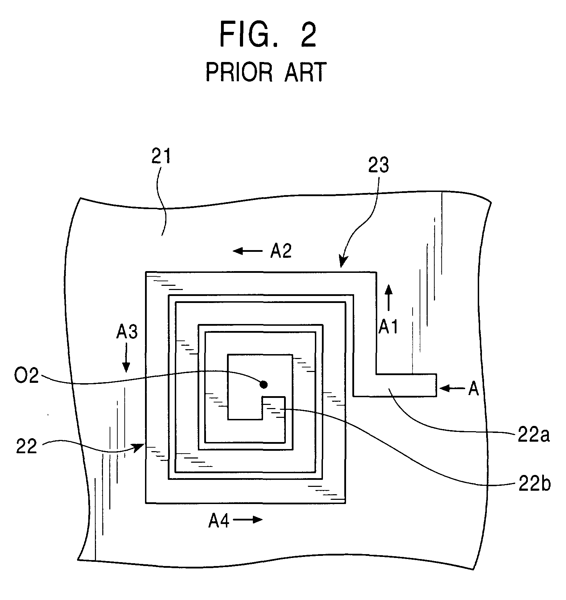

Referring to Fig. 2, the structure of a conventional spiral inductor is described. An insulating substrate 21 is formed of a printed wiring board. A spiral inductor 23 formed of a conductor 22 having a conductive pattern is fabricated on a surface of the insulating substrate 21.

The width of the conductor 22 forming the inductor 23 is the same from the outer side to the inner side of the spiral. The spacing between adjacent spiral turns of the conductor 22 is the same over the entire conductor 22.

A first end at the outer side and a second end at the inner side form terminal areas 22a and 22b, respectively. An electrical current A flows from the terminal area 22a in directions indicated by arrows A1, A2, A3, and A4, and the current A is led out from the terminal area 22b.

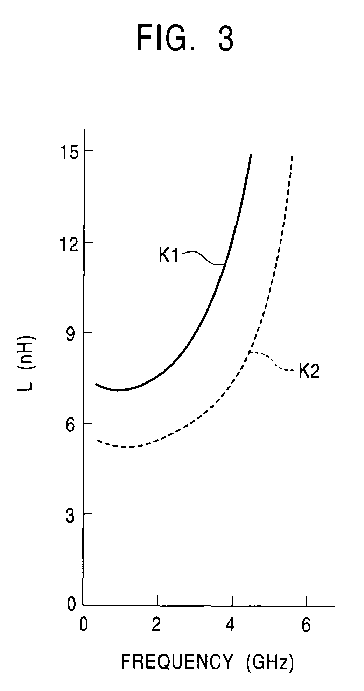

The conventional spiral inductor 23 shown in Fig. 2 is formed of the conductor 22 which has a width of 75 µm and is wound using three turns at a spacing of 25 µm. Referring to Fig. 3, a dotted line K2 indicates measured inductance values L (nH) for the conventional inductor 23.

As is clear from Fig. 3, the inductance L is small, i.e., 5 to 7 nH, at frequencies of 1.5 GHz to 4.0 GHz.

A factor causing the small inductance L is described as follows. Specifically, when the current A flows through the spiral inductor 23, the current A flows through opposed portions of the conductor 22, with respect to the center 02 of the inductor 23, at the opposite sides (the arrows A1 and A3 and the arrows A2 and A4). Concerning the conventional inductor 23, the conductor 22 at the inner side is near the center 02, and the opposed portions of the conductor 22 are greatly affected by magnetic lines of force. As a result, the inductance L becomes small.

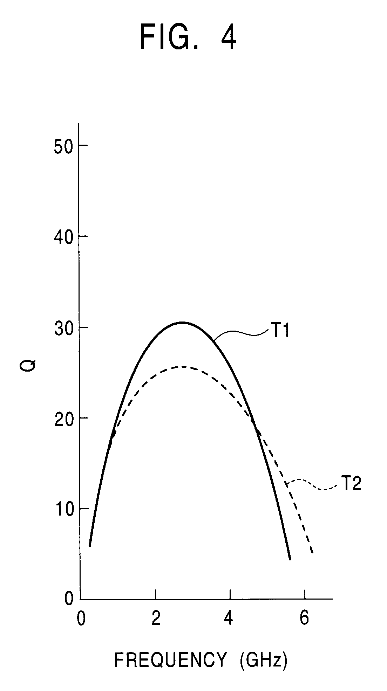

As the inductance L is reduced, the Q (quality factor) also becomes low. As a result, as indicated by a dotted line T2 in Fig. 4, measured Q values are low at frequencies of 1.5 GHz to 4.0 GHz.

Since the conventional spiral inductor 23 is formed so that it has the same width over the entire inductor 23, the inner portions of the conductor 22 are near the center 02. The magnetic lines of force greatly influence the opposed portions of the conductor 22, and hence the inductance L becomes small. Accordingly, the Q also becomes low.

### SUMMARY OF THE INVENTION

Accordingly, it is an object of the present invention to provide a high Q spiral inductor which can increase the inductance.

In order to solve the foregoing problems, a spiral inductor device according to the present invention is provided. The spiral inductor device includes a planar insulating substrate and a spiral inductor formed of a conductor having a conductive pattern, the conductor being provided at least on a surface of the insulating substrate. The spacing between adjacent spiral turns of the conductor is the same, and the width of the conductor at the inner side is smaller than the width of the conductor at the outer side.

The width of the conductor forming the spiral inductor may become smaller step by step from the outer side to the inner side.

The width of the conductor may become smaller every turn from the outer side to the inner side.

Alternatively, the width of the conductor forming the spiral inductor may gradually become smaller from the outer side to the inner side.

According to a spiral inductor of the present invention, the spacing between adjacent spiral turns of a conductor is the same over the entirety of the spiral inductor, and the width of an inner portion of the conductor is smaller than the width of an outer portion of the conductor. Since the inner portion of the conductor is far from the center, magnetic lines of force have a small effect on opposed portions of the conductor, and the inductance becomes large. It is thus possible to provide the spiral inductor which has a higher Q compared with that of a conventional spiral inductor.

Arranged as described above, the number of turns of the conductor is increased. Also, the spiral inductor is miniaturized, and the inductance is increased.

Since the width of the conductor forming the spiral inductor becomes smaller step by step from the outer side to the inner side, the design of the inductance is simplified. Alternatively, the present invention is equally applicable to a polyangular spiral inductor by reducing the width of a polyangular spiral conductor at each corner thereof.

Since the width of the conductor becomes smaller every turn from the outer side to the inner side, the design of the inductance is simplified. Alternatively, the present invention is equally applicable to a polyangular spiral inductor by reducing the width of a polyangular spiral conductor at each corner thereof.

Since the width of the conductor forming the spiral inductor gradually becomes smaller from the outer side to the inner side, the width of the conductor is reduced, and the number of turns of the conductor is increased. As a result, the spiral inductor is miniaturized, and the inductance is increased.

An embodiment of the present invention will now be described, by way of example only, with reference to the accompanying diagrammatic drawings, in which:
Fig. 1 is a plan view of a spiral inductor according to an embodiment of the present invention;
Fig. 2 is a plan view of a conventional spiral inductor;
Fig. 3 is a graph showing measured inductance values for the spiral inductors; and
Fig. 4 is a graph showing measured Q values for the spiral inductors.

### DESCRIPTION OF THE PREFERRED EMBODIMENTS

A spiral inductor according to the present invention will be described with reference to the following drawings:

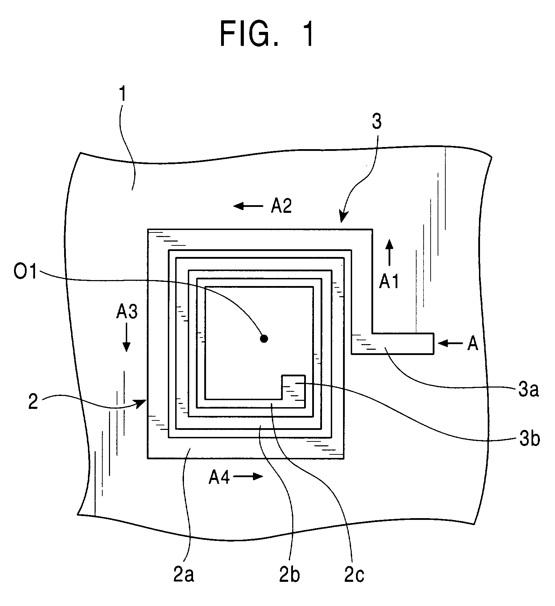

Fig. 1 is a plan view of a spiral inductor according to an embodiment of the present invention; Fig. 3 is a graph showing measured inductance values for the spiral inductor; and Fig. 4 is a graph showing measured Q values for the spiral inductor.

Referring to Fig. 1, the structure of the spiral inductor according to the present invention is described. An insulating substrate 1 is formed of a printed wiring board or the like. A spiral inductor 3 formed of a conductor 2 having a conductive pattern is fabricated on a surface of the insulating substrate 1. The width of an inner portion of the conductor 2 is smaller than the width of an outer portion of the conductor 2.

The inductor 3 is formed by winding the conductor 2 using three turns. The width of a conductor 2a, i.e., the outermost first turn, is large. The width of a conductor 2b, i.e., the second turn, is smaller than that of the conductor 2a. The width of a conductor 2c, i.e., the third turn, is smaller than that of the conductor 2b.

More specifically, the width of the conductor 2 forming the spiral inductor 3 becomes smaller step by step from the outer portion to the inner portion. The spacing between adjacent spiral turns of the conductor 2 is the same over the entire spiral inductor 3 from the outermost portion to the innermost portion.

A first end at the outer side of the inductor 2 and a second end at the inner side are terminal areas 3a and 3b, respectively. When an electrical current A flows from the terminal area 3a, the current A flows in directions indicated by arrows A1, A2, A3, and A4, and the current A is led out from the terminal area 3b.

With regard to the spiral inductor 3 shown in Fig. 1, the width of the conductor 2a is 75 µm, the width of the conductor 2b is 50 µm, and the width of the conductor 2c is 25 µm. The spiral conductor 3 is wound using three turns at a constant spacing of 25 µm. Referring to Fig. 3, a solid line K1 indicates measured inductance values L (nH) for the inductor 3 according to the present invention.

As is clear from Fig. 3, the inductance L of the spiral inductor 3 according to the present invention is large, i.e., 7.5 to 12 nH, at frequencies of 1.5 GHz to 4.0 GHz, compared with 5 to 7 nH of the inductance L of the conventional spiral inductor.

A factor causing the large inductance L is described as follows. Specifically, when the current A flows through the spiral inductor 3, the current A flows through opposed portions of the conductor 2, with respect to the center O1 of the inductor 3, at the opposite sides (the arrows A1 and A3 and the arrows A2 and A4). Since the inductor 3 is formed such that the width of the conductor 2 is smaller at the inner side, the conductor 2c at the inner side is far from the center O1. Thus, magnetic lines of force have a small effect on the opposed portions of the conductor 2, and the inductance L becomes large.

As the inductance L becomes large, the Q also becomes high. As a result, as indicated by a solid line T1 in Fig. 4, the spiral inductor 3 of the present invention have higher measured Q values compared with those for the conventional spiral inductor at frequencies of 1.5 GHz to 4.0 GHz.

Although the present invention has been descried using a quadrangular spiral inductor in this embodiment, a triangular spiral inductor, a polyangular (pentagonal or more) spiral inductor, or a circular spiral inductor can be used instead.

Although it has been described in this embodiment that the width of the conductor 2 becomes smaller every turn, the present invention is not limited to this embodiment. Specifically, when the present invention is applied to a polyangular spiral inductor, the width of the conductor 2 can be reduced at every angle or side. When a polyangular or a circular spiral inductor is used, the width of the conductor 2 can be gradually reduced.

## Claims

1. A spiral inductor device comprising:
a planar insulating substrate; and
a spiral inductor formed of a conductor having a conductive pattern, said conductor being provided at least on a surface of said insulating substrate;
wherein the spacing between adjacent spiral turns of the conductor is the same, and the width of the conductor at the inner side is smaller than the width of the conductor at the outer side.

2. A spiral inductor device according to Claim 1,
wherein the width of the conductor forming said spiral inductor becomes smaller step by step from the outer side to the inner side.

3. A spiral inductor device according to Claim 2,
wherein the width of the conductor becomes smaller every turn from the outer side to the inner side.

4. A spiral inductor device according to Claim 1,
wherein the width of the conductor forming said spiral inductor gradually becomes smaller from the outer side to the inner side.
